Europäisches Patentamt

European Patent Office

Office européen des brevets

(19)

(11) **EP 0 761 723 B1**

(12) **EUROPÄISCHE PATENTSCHRIFT**

(45) Veröffentlichungstag und Bekanntmachung des Hinweises auf die Patenterteilung:
**06.02.2002 Patentblatt 2002/06**

(51) Int Cl.⁷: **C08G 77/20**, C08G 77/02, C08L 83/07
// (C08L83/07, 83:05, 83:07)

(21) Anmeldenummer: **96113159.6**

(22) Anmeldetag: **16.08.1996**

(54) **Flüssige Organopolysiloxan-Harze, ein Verfahren zu deren Herstellung sowie niedrigviskose Polydiorgano-siloxan-Zusammensetzung und deren Verwendung**

Liquid organopolysiloxane resins, process for their preparation and low viscous polydiorganosiloxane compositions and their use

Résine d'organopolysiloxanes liquides, procédé pour leur préparation, compositions de polydiorganosiloxanes à basse viscosité et leur application

(84) Benannte Vertragsstaaten:
**DE FR GB IT**

(30) Priorität: **28.08.1995 DE 19531568**

(43) Veröffentlichungstag der Anmeldung:
**12.03.1997 Patentblatt 1997/11**

(73) Patentinhaber: **GE Bayer Silicones GmbH & Co. KG**
**40699 Erkrath (DE)**

(72) Erfinder:
• **Friebe, Robert, Dr.**
  **51373 Leverkusen (DE)**
• **Eversheim, Hubertus**
  **42929 Wermelskirchen (DE)**

(56) Entgegenhaltungen:
**EP-A- 0 108 208       EP-A- 0 382 338**
**EP-A- 0 555 050       EP-A- 0 651 021**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft flüssige Organopolysiloxan-Harze, ein Verfahren zu deren Herstellung, niedrigviskose Polydiorganosiloxan-Zusammensetzungen, enthaltend flüssige Organopolysiloxan-Harze, und deren Verwendung.

Die erfindungsgemäßen Organopolysiloxan-Harze zeichnen sich durch ein bestimmtes Verhältnis der $(R_3SiO_{1/2})$-, $(R_2SiO)$-, $(RO_{1/2})$- und $(SiO_2)$-Einheiten aus.

Die erfindungsgemäßen niedrigviskosen Polydiorganosiloxan-Zusammensetzungen, enthaltend die erfindungsgemäßen flüssigen Organopolysiloxan-Harze können durch Hydrosilylierungsreaktionen bei Raumtemperatur bzw. erhöhten Temperaturen zu Siliconelastomeren vulkanisiert werden.

Organopolysiloxan-Harze mit $(R_3SiO_{1/2})$- und $(SiO_2)$-Gruppen sind aus der Patentliteratur bekannt und wurden in zahlreichen Publikationen beschrieben. Die Herstellung dieser Harze erfolgt üblicherweise durch Hydrolyse der entsprechenden Triorganochlorsilane und Tetraalkoxysilane bzw. ihrer Teilhydrolysate in Gegenwart eines organischen aromatischen Lösungsmittes wie z.B. Xylol oder aliphatischer Kohlenwasserstoffe (EP-A- 555 050). Es werden auch Herstellverfahren beschrieben, die von Organosiloxanen mit $(R_3SiO_{1/2})$-Endgruppen, z.B. Hexamethyldisiloxan, und Tetraalkoxysilanen ausgehen (EP-A- 294 277).

Die Herstellung flüssiger Organopolysiloxan-Harze mit $(R_3SiO_{1/2})$-, $(RSiO_{3/2})$- und $(SiO_2)$-Einheiten, wobei R u.a. einen aliphatischen oder aromatischen Kohlenwasserstoffrest darstellt, wird in EP-A- 389 138 beschrieben.

Aus US 5 373 078 sind weiterhin niedrigviskose vernetzbare Organosiloxan-Zusammensetzungen bekannt, die flüssige Organopolysiloxan-Harze mit $(R_3SiO_{1/2})$- und $(SiO_2)$-Einheiten enthalten, wobei R einen $C_1$ bis $C_{10}$-Alkylrest darstellt und das Verhältnis der $(R_3SiO_{1/2})$- zu $(SiO_2)$-Einheiten zwischen 1:1 und 2:1 liegt. Diese Produkte dienen jedoch nur zur Viskositätssenkung der Massen und werden aufgrund der fehlenden ungesättigten Reste nicht in das Elastomer eingebaut.

Bei einer weiteren großen Gruppe aus der Literatur bekannter Organopolysiloxan-Harze mit $(CH_2=CH-Si(CH_3)_2O_{1/2})$-, $((CH_3)_3SiO_{1/2})$- und $(SiO_2)$-Einheiten handelt es sich um bei Raumtemperatur feste Produkte. Harze dieser Art finden in verschiedenen Anwendungen Einsatz.

In US 3 884 866 wird beispielsweise die Verwendung solcher Harze zur mechanischen Verstärkung von Siliconelastomeren beschrieben. Dabei können die Harze aufgrund der vorhandenen Vinyl-Gruppen im Verlauf der Hydrosilylierungsreaktion mit in das Netzwerk eingebaut werden.

In DAS 1 171 614 werden Vinylgruppen-haltige Siliconharze mit insgesamt 0,6 bis 1,0 $(CH_2=CH-Si(CH_3)_2O_{1/2})$- und $((CH_3)_3SiO_{1/2})$- Einheiten je $(SiO_2)$-Einheit und ihre Verwendung in Gießmassen beschrieben.

US 3 284 406 offenbart eine Organopolysiloxan-Zusammensetzung, die Harze mit $(CH_2=CH-Si(CH_3)_2O_{1/2})$-, $((CH_3)_3SiO_{1/2})$- und $(SiO_2)$-Einheiten enthält, worin das Verhältnis der Summe der $(CH_2=CH-Si(CH_3)_2O_{1/2})$- und $((CH_3)_3SiO_{1/2})$- zu $(SiO_2)$-Einheiten von 0,6:1 bis 1:1 ist.

Aus US 3 436 366 sind Zusammensetzungen mit verbesserten mechanischen Eigenschaften bekannt, die wiederum Harze der vorangenannten Struktur enthalten, wobei jedoch das Verhältnis der $(CH_2=H-Si(CH_3)_2O_{1/2})$- und $((CH_3)_3SiO_{1/2})$-Einheiten je $(SiO_2)$-Einheit zwischen 0,5:1 bis 1:1 liegt.

In DE-A-3 423 770 werden transparente Membranstrukturen beschrieben, die aus vernetzbaren Silicon-Zusammensetzungen hergestellt werden, die als eine wesentliche Komponente Organopolysiloxan-Harze mit $(CH_2=CH-Si(CH_3)_2O_{1/2})$-, $((CH_3)_3SiO_{1/2})$-, $((CH_3)_2SiO)$- und $(SiO_2)$-Einheiten enthalten, wobei das Verhältnis der $(R_3SiO_{1/2})$- zu $(SiO_2)$-Einheiten zwischen 0,5:1 bis 1:1, und das der $(R_2SiO)$- zu $(SiO_2)$-Einheiten im Bereich von 0,1:1 liegen kann.

Bei allen diesen Harzen handelt es sich jedoch um feste Produkte, die in einem geeigneten Lösungsmittel, gegebenenfalls in einem Siliconpolymer, gehandhabt werden müssen. Dies wirft im Hinblick auf ihre Handhabung in der Praxis eine Reihe von Problemen auf. So müssen die lösungsmittelhaltigen Harze immer vor ihrem Einsatz vom Lösungsmittel befreit werden, was einen zusätzlichen Aufwand bedeutet. Setzt man feste Organopolysiloxan-Harze in Polydiorganosiloxan-Zusammensetzungen ein, bei denen es aufgrund der Anwendung besonders auf niedrige Viskositäten ankommt, wie z.B. im bei Abform- und Vergußmassen, so kommt es zu einer unerwünschten Erhöhung der Viskosität.

Die Verwendung von flüssigen Polydiorganosiloxan Zusammensetzungen als Abform- und Vergußmassen in verschiedenen Anwendungsbereichen ist nach dem Stand der Technik schon seit langem bekannt. Neben den mechanischen Eigenschaften der vulkanisierten Elastomere wie Reißfestigkeit, Dehnung und insbesondere Weiterreißfestigkeit spielen auch ihre Verarbeitungseigenschaften eine große Rolle. Dabei werden insbesondere an die Reaktivität der Massen und ihre Viskosität besondere Anforderungen gestellt. Um eine gute Verarbeitung zu gewährleisten, werden besonders niedrigviskose Produkte gewünscht, die sich jedoch auch durch gute mechanische Elastomereigenschaften auszeichnen sollen.

Es sind verschiedene Maßnahmen bekannt, die die mechanischen Vulkani-sateigenschaften niedrigviskoser Polydiorganosiloxan-Zusammensetzungen verbes-sern. Verstärkenden Füllstoffen wie z.B. pyrogenen Kieselsäuren kommt dabei eine besondere Bedeutung zu. Leider führt jedoch die Einarbeitung von größeren Mengen solcher Füllstoffe zu einem unerwünschten Anstieg der Viskosität, so daß dies nur in einem begrenzten Umfang möglich ist. Auch die Kettenlänge des verwendeten Polymers beeinflußt positiv die mechanischen Eigenschaften der Produkte, wobei auch hier mit Zunahme der Kettenlänge die Viskosität steigt.

Aufgabe der vorliegenden Erfindung war es daher, flüssige Organopolysiloxan-Harze bereitzustellen, die sich zur mechanischen Verstärkung von Siliconelastomeren, die mit Hilfe der platinkatalysierten Hydrosilylierungsreaktion vulkanisiert werden können, eignen und zu dem bei dem Einsatz in flüssigen Polydiorganosiloxan-Zusammensetzungen zu niedrigviskosen Mischungen mit guten mechanischen Eigenschaften führen.

Überraschenderweise wurde nun gefunden, daß die erfindungsgemäßen Organopolysiloxan-Harze, die über ein bestimmtes Verhältnis von $(R_3SiO_{1/2})$-, $(R_2SiO)$-, $(RO_{1/2})$- und $(SiO_2)$-Einheiten verfügen, bei Raumtemperatur flüssig sind und zudem sehr gut zur mechanischen Verstärkung von Siliconelastomeren, insbesondere niedrigviskosen Polydiorganosiloxan-Zusammensetzungen geeignet sind.

Gegenstand der vorliegenden Erfindungen sind daher flüssige Organopolysiloxan-Harze der mittleren Zusammensetzung:

$$[R^1Si(CH_3)_2O_{1/2}]_a \ [(CH_3)_3SiO_{1/2}]_b \ [R^2O_{1/2}]_c \ [R^1Si(CH_3)O]_d \ [(CH_3)_2SiO]_e \ [SiO_2],$$

wobei

| | |
|---|---|
| $R^1$ | einen $C_2$-$C_8$-Alkenylrest, bevorzugt Vinyl-Rest, |
| $R^2$ | gegebenenfalls substituierte, lineare oder verzweigte $C_1$-$C_8$-Alkyl-, vorzugsweise Methyl- und/oder Ethyl-Gruppen bzw. Mischungen daraus darstellt, |
| a+b+c+d+e | Werte im Bereich von 1,0 bis 6,0, bevorzugt zwischen 1,0 und 3,0, ganz besonders bevorzugt zwischen 1,0 und 2,0, liegt, |
| d + e | Werte von 0 bis 3,0, bevorzugt 0,1 bis 2,0, ganz besonders bevorzugt 0,4 bis 1,0 einnehmen können, |

und das Harz eine Viskosität von 0,1 bis 1000 Pas bei 25°C besitzt,

sowie der Alkenyl- bzw. Vinyl-Gehalt des Harzes in einem Bereich von 0,4 bis 4,0 mmol/g, bevorzugt von 0,5 bis 2,0 liegt.

Gegenstand der vorliegenden Erfindung ist zudem ein Verfahren zur Herstellung der erfindungsgemäßen Organopolysiloxan-Harze, wonach mindestens ein Tetraalkoxysilan und/oder dessen Teilhydrolysate mit mindestens einem Organosiloxan und einer starken Säure als Katalysator in Gegenwart von Wasser und gegebenenfalls einem organischen Lösemittel bei Temperaturen > 40°C umgesetzt wird.

Die weitere Aufarbeitung , wie Neutralisation, Filtration und Entfernung flüchtiger Bestandteile erfolgt nach dem Stand der Technik.

Der Begriff Tetraalkoxysilan umfaßt alle nach der Stand der Technik bekannten Verbindungen, wie z.B. Tetra $(C_1$-$C_{18})$-alkoxysilane. Bevorzugt dabei sind Tetraethoxysilan, Tetramethoxysilan und deren Teilhydrolysate.

Als Organosilane im Sinne der Erfindung können alle bekannten kurz- bzw. langkettigen, linearen oder cyclischen Siloxane, mit $C_1$-$C_8$-Alkyl- und $C_2$-$C_8$-Alkenylresten eingesetzt werden. Bevorzugt dabei sind Hexamethyldisiloxan, Tetramethyldivinyldisiloxan, Octamethylcyclotetrasiloxan und Tetramethyltetravinylcyclotetrasiloxan.

Als Säuren im Sinne der Erfindung können alle bekannten starken Mineralsäuren bzw. starken organischen Säuren eingesetzt werden. Bevorzugt werden Schwefelsäure und Perfluorbutansulfonsäure.

Als Lösemittel im Sinne der Erfindung können alle bekannten organischen Lösemittel eingesetzt werden. Bevorzugt werden Xylol, Hexan und Toluol.

In einer besonders bevorzugten Ausführungsform der Erfindung wird das Verfahren bei Temperaturen zwischen 80 und 150°C durchgeführt.

Gegenstand der vorliegenden Erfindung sind niedrigviskose Polydiorganosiloxan-Zusammensetzungen, enthaltend :

a) mindestens ein erfindungsgemäßes flüssiges Organopolysiloxanharz der mittleren Zusammensetzung

$$[R^1Si(CH_3)_2O_{1/2}]_a \ [(CH_3)_3SiO_{1/2}]_b \ [R^2O_{1/2}]_c \ [R^1Si(CH_3)O]_d \ [(CH_3)_2SiO]_e \ [SiO_2],$$

wobei

| | |
|---|---|
| $R^1$ | einen $C_2$-$C_8$-Alkenylrest, bevorzugt Vinyl-Rest, |

$R^2$ gegebenenfalls substituierte, lineare oder verzweigte $C_1$-$C_8$-Alkyl-, vorzugsweise Methyl- und/oder Ethyl-Gruppen bzw. Mischungen daraus darstellt,

a+b+c+d+e im Bereich von 1,0 bis 4,0, bevorzugt zwischen 1,0 und 3,0, ganz besonders bevorzugt zwischen 1,0 und 2,0 liegt,

d+e Werte von 0 bis 3,0, bevorzugt 0 bis 2,0, ganz besonders bevorzugt 0 bis 1,0 einnehmen können,

und das Harz eine Viskosität von 0,1 bis 1000 Pas bei 25°C besitzt,
sowie der Alkenyl- bzw. Vinyl-Gehalt des Harzes in einem Bereich von 0,4 bis 4,0 mmol/g, bevorzugt von 0,5 bis 2,0 liegt,

b) mindestens ein Alkenylgruppen-haltiges vernetzungsfähiges Polydiorganosiloxan der Formel $R^3$-Si$(R^4)_2$O-[-Si$(R^3)_2$O]$_x$--Si$(R^4)_2R^3$, wobei

$R^3$ und $R^4$ gegebenenfalls substituierte, lineare oder verzweigte $C_1$-$C_8$-Alkyl-, vorzugsweise Methyl-, $C_6$-$C_{14}$-Aryl-, vorzugsweise Phenyl- oder $C_2$-$C_8$-Alkenyl-, vorzugsweise Vinylreste bedeuten und x in einem Bereich liegt, daß die Viskosität des Polymeren 0,1 bis 1000 Pas bei 25°C beträgt,

c) mindestens ein flüssiges Polyorganohydrogensiloxan der allgemeinen Formel

$$R^5\text{-Si}(R^6)_2\text{O-[-Si}(R^6)_2\text{O]}_n\text{-[-SiH}(R^6)\text{O]}_m\text{-Si}(R^6)_2R^5,$$

wobei

$R^6$ gegebenenfalls substituierte, lineare oder verzweigte $C_1$-$C_8$-Alkyl-, vorzugsweise Methyl-, $C_6$-$C_{14}$-Aryl-, vorzugsweise Phenyl- oder $C_2$-$C_8$-Alkenyl-, vorzugsweise Vinylreste bedeuten

$R^5$ die Bedeutung von $R^6$ oder Wasserstoff hat,

m > 2 für $R^6$ ungleich H und für m= l ist $R^6$ = H und

n + m Werte einnehmen, daß die Viskosität des Polymers in einem Bereich von 5 bis 10000 mPas bei 25°C liegt,

d) mindestens ein Hydrosilylierungskatalysator aus der Gruppe der Platinmetalle bzw. deren Verbindungen,

e) gegebenenfalls ein oder mehrere Füllstoffe und

f) gegebenenfalls weiterer Hilfstoffe wie z.B. Pigmente, Weichmacher und Inhibitoren.

Polydiorganosiloxane b) im Sinne der Erfindung sind alle nach dem Stand der Technik bekannten über die Hydrosilylierungsreaktion vernetzungsfähigen linearen Alkenyl-Gruppen haltigen Polydimethylsiloxane, die zudem geringe Anteile an verzweigten, gegebenenfalls substituierten Organylsiloxyeinheiten enthalten können. Als besonders bevorzugte Alkenyl-Gruppe ist die Vinylgruppe zu nennen. Bevorzugte Polydiorganosiloxane b) sind Dimethylvinylsiloxy-endgestoppte Polydimethylsiloxane mit einer Viskosität von 0,1 bis 1000 Pas bei 25°C, bevorzugt 0,1 bis 300 Pas.
Flüssige Polyorganohydrogensiloxane c) im Sinne der Erfindung sind vorzugsweise niedrigviskose Polymere mit einer mittleren Zusammensetzung:

$$(CH_3)_3\text{SiO-[-Si}(CH_3)_2\text{O]}_5\text{-[-SiH}(CH_3)\text{O]}_{20}\text{-Si}(CH_3)_3,$$

$$(CH_3)_3\text{SiO-[-Si}(CH_3)_2\text{O]}_{10}\text{-[-SiH}(CH_3)\text{O]}_{30}\text{-Si}(CH_3)_3,$$

$$(CH_3)_3\text{SiO-[-Si}(CH_3)_2\text{O]}_3\text{-[-SiH}(CH_3)\text{O]}_{10}\text{-Si}(CH_3)_3$$

4

oder SiH-gruppenhaltige Polysiloxane, die als weitere Gruppen $(SiO_2)$- und $(RSiO_{3/2})$-Einheiten enthalten.

Die Konzentration des Polyorganohydrogensiloxans c) in der vernetzbaren Polydiorganosiloxan-Zusammensetzung wird vorzugsweise so gewählt, daß das molare Verhältnis der Hydrogen- zu Alkenyl-Gruppen zwischen 0,5:1 bis zu 10:1 beträgt. Besonders bevorzugt sind Verhältnisse zwischen 1:1 und 3:1.

Hydrosilylierungskatalysatoren d) im Sinne der Erfindung sind alle üblicherweise für additionsvernetzende Systeme eingesetzten Katalysatoren. Bevorzugt hierfür sind die Metalle der Platin-Gruppe, wie z.B Platin, Palladium und Rhodium bzw deren Verbindungen. Besonders geeignet sind Platin(0)-Komplexe mit Vinylsiloxanen als Liganden, Hexachloroplatin(IV)-säure und deren Komplexe mit ethylenischen ungesättigten Verbindungen, wie Olefinen und Vinylsiloxanen. Die Platinkonzentration im Hydrosilylierungskatalysators ist vorzugsweise 0,1 bis 500 ppm, bezogen auf die Gesamtmischung aus den Komponenten a) bis f), besonders bevorzugt von 1 bis 250 ppm.

Füllstoffe e) im Sinne der Erfindung sind verstärkende sowie nicht verstärkende Materialien. Verstärkende Füllstoffe sind vorzugsweise pyrogene oder gefällte, feinteilige Kieselsäuren mit einer BET-Oberfläche von 50 bis 500 $m^2/g$ geeignet. Derartige Füllstoffe können oberflächenmodifiziert sein, z.B. mit siliziumorganischen Verbindungen. Die Modifizierung kann auch während der Einarbeitung in das Polymer durch Zusatz von z.B. Hexamethyldisilazan oder 1,3-Divinyl-1,1,3,3-tetramethyldisilazan unter Zusatz von Wasser erfolgen. Weiterhin können als Füllstoffe Materialien wie z.B. Diatomeenerden, feinteilige Quarzmehle, amorphe Kieselsäuren, Calciumcarbonat, Metalloxide, wie Aluminiumoxid, Zinkoxid, Titandioxid oder Eisenoxide, und Ruße eingesetzt werden.

Als bevorzugte erfindungsgemäße Hilfsstoffe f) sind Inhibitoren zu nennen. Diese Verbindungen können eingesetzt werden um die Reaktivität der Hydrosilylierungsreaktion zu steuern. Besonders bevorzugt hierfür sind acetylenische Alkohole, wie z.B. 2-Methyl-butin(3)-ol(2), Ethinylcyclohexanol, Tetramethylvinylcyclotetrasiloxan oder 1,3-Divinyl-1,1,3,3-tetramethyldivinyldisiloxan.

In einer bevorzugten Ausführungsform der vorliegenden Erfindung weisen die erfindungsgemäßen Polydiorganosiloxan-Zusammensetzungen folgende Zusammensetzung auf:

100 Gew.-Teile a)
20 bis 100 Gew.-Teile b)
1 bis 50 Gew.-Teile c)
1 bis 250 ppm d)
0 bis 200 Gew.-Teile e).

Die Herstellung der erfindungsgemäßen Polydiorganosiloxan-Zusammensetzungen kann durch Vermischen aller Komponenten in beliebiger Reihenfolge bei Raumtemperatur erfolgen. Alle nach dem Stand der Technik bekannten Mischaggregate können hierfür verwendet werden. Beispiele dafür sind Dissolver, Planetenmischer, Butterfly-Mischer oder kontinuierlich arbeitende Mischschnecken. Gegebenenfalls können die Zusammensetzungen im Verlauf der Herstellung gekühlt werden um eine vorzeitige Vulkanisation des Materials zu verhindern.

In einer bevorzugten Ausführungsform erfolgt die Herstellung der erfindungsgemäßen Polydiorganosiloxan-Zusammensetzungen in der Form von 2 getrennten Komponenten, die erst unmittelbar vor der Anwendung miteinander homogen vermischt werden. Dabei enthält üblicherweise die eine Komponente das Polyorganohydrogensiloxan b) und die zweite Komponente den Hydrosilylierungskatalysator d) getrennt voneinander.

Gegenstand der Erfindung ist zudem die Verwendung der erfindungsgemäßen niedrigviskosen Polydiorganosiloxan-Zusammensetzungen als Verguß- und Einbettungsmassen zur Abdichtung von elektronischen und elektrischen Bauteilen, zur Herstellung von Abform- und Abdruckmassen sowie als Beschichtungsmassen für Gewebe und andere verschiedene Materialien.

Durch die folgenden Beispiele soll die Erfindung näher erläutert werden. Die Erfindung ist jedoch nicht auf die Beispiele beschränkt.

## Beispiele

## Organopolysiloxan-Harze (Beispiele 1 bis 4)

## Beispiel 1

In einem Reaktionsgefäß ausgestattet mit Rührer, Thermometer, Rücklaufteiler, Kühler und Tropftrichter wurden unter Stickstoffüberlagerung 1050 g eines teilhydrolisierten Tetraethoxysilans mit 40% $SiO_2$, käuflich bei der Firma Hüls AG unter der Bezeichnung Dynasilan 40, 634 g Hexamethyldisiloxan, 65,1 g Tetramethyldivinyldisiloxan, 50g Ethanol und 1000 g Xylol vorgelegt. Zu dieser Mischung wird 1 g konz. Schwefelsäure und 0,5 g Perfluorbutansulfonsäure gegeben, eine Stunde bei ca. 100°C unter Rückfluß gerührt und 200 g Wasser unter Rückfluß innerhalb einer Stunde zudosiert. Anschließend rührt man weitere 2 Stunden bei Rückfluß nach und nimmt bei einer maximalen Temperatur des Reaktionsgemisches von 100°C bei 1013 hPa das Destillat ab. Es wird weitere 4 Stunden bei 100°C nachgerührt. Nach Neutralisation der Reaktionsmischung mit Soda/Ethanol wird filtriert und das Filtrat 1 Stunde bei 150°C und einem Druck < 5 hPa von flüchtigen Verbindungen befreit. Nach Abkühlen erhält man ein flüssiges, klares, farbloses bis leicht gelbliches Produkt mit 0,6 mmol Vinyl/g und einer Viskosität von ca. 5 Pas. Aus dem $^1$H und $^{29}$Si-NMR Spektren des Produktes ergibt sich eine mittlere Zusammensetzung von $[CH_2=CH-Si(CH_3)_2O_{1/2}]_{0,1}$ $[(CH_3)_3SiO_{1/2}]_{1,0}$ $[C_2H_5O_{1/2}]_{0,3}$ $[SiO_2]$.

**Beispiel 2**

Es wurden 1000 g teilhydrolisiertes Tetraethoxysilan mit 40% $SiO_2$, 562 g Hexamethyldisiloxan und 98 g Tetramethyldivinyldisiloxan in 1061 g Xylol mit 1 g Schwefelsäure und 0,5 g Perfluorbutansulfonsäure entsprechend Beispiel 1. umgesetzt. Man erhält ein flüssiges, klares, farbloses bis leicht gelbliches Produkt mit 0,9 mmol Vinyl/g und einer Viskosität von ca. 1,8 Pas. Die mittlere Zusammensetzung ergibt sich aus den $^1$H und $^{29}$Si NMR Spektren mit

$$[CH_2=CH-Si(CH_3)_2O_{1/2}]_{0,18}\ [(CH_3)_3SiO_{1/2}]_{1,0}\ [C_2H_5O_{1/2}]_{0,37}\ [SiO_2].$$

**Beispiel 3**

Es wurden 839 g teilhydrolisiertes Tetraethoxysilan mit 40% $SiO_2$, 205g Octamethylcyclotetrasiloxan, 459 g Hexamethyldisiloxan, 91 g Tetramethyldivinyldisiloxan, 50g Ethanol und 272 g Xylol mit 1 g Schwefelsäure und 0,5 g Perfluorbutansulfonsäure analog dem in Beispiel 1. beschrieben Verfahren umgesetzt. Man erhält ein flüssiges, klares, farbloses bis leicht gelbliches Produkt mit 0,8 mmol Vinyl/g und einer Viskosität von ca. 3,5 Pas. Die mittlere Zusammensetzung ergibt sich aus den $^1$H und $^{29}$Si NMR Spektren mit

$$[CH_2=CH-Si(CH_3)_2O_{1/2}]_{0,15}\ [(CH_3)_3SiO_{1/2}]_{0,75}\ [C_2H_5O_{1/2}]_{0,2}\ [(CH_3)_2SiO]_{0,45}[SiO_2].$$

**Beispiel 4**

Es wurden 887 g teilhydrolisiertes Tetraethoxysilan mit 40% $SiO_2$, 479 g Hexamethyldisiloxan, und 265 g Tetramethyltetravinylcyclotetrasiloxan in 1000 g Xylol mit 1 g Schwefelsäure und 0,5 g, 205g Octamethylcyclotetrasiloxan, Perfluorbutansulfonsäure entsprechend Beispiel 1. umgesetzt. Man erhält eine klares, farbloses bis leicht gelbliche Flüssigkeit mit 1,7 mmol Vinyl/g und einer Viskosität von ca. 870 mPas. Die mittlere Zusammensetzung ergibt sich aus den $^1$H und $^{29}$Si NMR Spektren mit

$$[CH_2=CH-Si(CH_3)O]_{0,32}\ [(CH_3)_3SiO_{1/2}]_{0,69}\ [C_2H_5O_{1/2}]_{0,2}\ [(CH_3)_2SiO]_{0,52}[SiO_2].$$

**Vernetzbare Polydiorganosiloxan-Zusammensetzungen (Beispiele 5 bis 11)**

Mit diesen Beispielen wird der Einsatz der erfindungsgemäßen Organopolysiloxan-Harze in vernetzbaren Polydiorganosiloxan-Zusammensetzungen demonstriert. Hierzu wurden aus den im folgenden aufgeführten Bestandteilen homogene Mischungen hergestellt, deren Zusammensetzung Tabelle 1 zu entnehmen ist:

1) Dimethylvinylsiloxy-endgestopptes Polydimethylsiloxan mit einer Viskosität von 65 Pas bei 25°C,

2a) Organopolysiloxan-Harz aus Beispiel 1,

2b) Organopolysiloxan-Harz aus Beispiel 2,

2c) Organopolysiloxan-Harz aus Beispiel 3,

2d) festes Organopolysiloxan-Harz mit $(CH_2=CH-Si(CH_3)_2O_{1/2})$-, $((CH_3)_3SiO_{1/2})$-, $((CH_3)_2SiO)$- und $(SiO_2)$-Einheiten und einem Vinylgehalt von 0,7 mmol/g,

2e) Organopolysiloxan-Harz aus Beispiel 4,

3) Polyorganohydrogensiloxan mit einem SiH-Gehalt von 8,3 mmol/g, das im wesentlichen aus $(SiO_2)$- und $((CH_3)_2HSiO_{1/2})$-Einheiten aufgebaut ist,

4) gemahlenes Quarzmehl mit einer mittleren Korngröße von 3 µm

5) Platinkatalysator in Form eines Pt(0)-Komplexes in Tetramethylvinyltetracyclosiloxan mit 2% Platin,

6) Tetramethylvinyltetracyclosiloxan als Inhibitor,

7) blaue Farbpaste.

Nach Fertigstellung der Mischung wurden zunächst die Viskosität der Zusammensetzungen ermittelt. Die Viskositätsmessung wurde mit einem Kegel-Platte-Viskosimeter der Fa. Physica durchgeführt. Anschließend wurden die Massen in 2 mm tiefe Platten gegossen, gepreßt und 10 Minuten bei 175°C vulkanisiert. Die ausgehärten Elastomerplatten mit einer Schichtdicke von ca 2 mm wurden anschließend auf ihre mechanischen Eigenschaften hin untersucht. Hierzu wurden aus dem Material Prüfkörper gemäß den angegebenen DIN bzw. ASTM-Vorschriften (siehe Tabelle 2) ausgeschnitten und geprüft.

Tabelle 1

| Zusammensetzungen der Mischungen. | | | | | | | |
|---|---|---|---|---|---|---|---|
| Bestandteil [Gew.-Teile] | 5.* | 6. | 7. | 8. | 9. | 10. | 11. |
| 1) | 75 | 70 | 60 | 75 | 75 | 75 | 70 |
| 2a) | 0 | 30 | 40 | 0 | 0 | 0 | 0 |
| 2b) | 0 | 0 | 0 | 25 | 0 | 0 | 0 |
| 2c) | 0 | 0 | 0 | 0 | 0 | 25 | 30 |
| 2d) | 25 | 0 | 0 | 0 | 0 | 0 | 0 |
| 2e) | 0 | 0 | 0 | 0 | 25 | 0 | 0 |
| 3) | 7,3 | 7,6 | 7,6 | 8,9 | 12,3 | 6,3 | 7,3 |
| 4) | 40 | 40 | 40 | 40 | 40 | 40 | 40 |
| 5) | 0,13 | 0,13 | 0,13 | 0,13 | 0,13 | 0,13 | 0,13 |
| 6) | 0,13 | 0,13 | 0,13 | 0,13 | 0,13 | 0,13 | 0,13 |
| 7) | 1,35 | 1,35 | 1,35 | 1,35 | 1,35 | 1,35 | 1,35 |

\* Vergleichsbeispiel

Tabelle 2

| Mechanische Eigenschaften der vulkanisierten Polydiorganosiloxan-Zusammensetzungen. | | | | | | | |
|---|---|---|---|---|---|---|---|
| Beispiel Nr. / Eigenschaften | 5.* | 6. | 7. | 8. | 9. | 10. | 11. |
| Viskosität [Pas] | 74 | 42 | 31 | 50 | 52 | 59 | 51 |
| Härte [Shore A] (DIN 53505) | 52 | 42 | 54 | 46 | 67 | 49 | 54 |
| Bruchdehnung [%] (DIN 53504) | 170 | 280 | 240 | 270 | 190 | 290 | 340 |
| Zugfestigkeit [MPa] (DIN 53504) | 4,5 | 4,8 | 5,2 | 5,8 | 6,1 | 5,3 | 5,1 |
| Zugspannung bei 100% Dehnung [MPa] (DIN 53504) | 3,3 | 2,1 | 3,6 | 2,9 | 4,6 | 2,6 | 2,8 |
| Weiterreißfestigkeit [N/mm] (ASTM 624 B) | 11 | 10 | 16 | 11 | 10 | 9 | 11 |
| Weiterreißfestigkeit [N/mm] (DIN 53515) | 5 | 4 | 6 | 4 | 4 | 3 | 4 |

\* Vergleichsbeispiel

**Erläuterungen zu den Beispielen 5 bis 11**

Bei dem Vergleichsversuch 5 wurde ein festes Organopolysiloxan-Harz verwendet, wie es aus der Literatur bekannt ist. Dieser Versuch stellt somit ein Beispiel nach dem Stand der Technik dar. Wie aus den Ergebnissen der Beispiele 6 bis 11 und einem Vergleich mit Beispiel 5 zu entnehmen ist, wirken die erfindungsgemäßen flüssigen Organopolysiloxan-Harze ebenfalls verstärkend auf die mechanischen Eigenschaften der Elastomere. Dabei haben die unvulkanisierten Zusammensetzungen deutlich niedrigere Viskositäten, und somit auch verbesserte Verarbeitungseigenschaften, als die Zusammensetzung 5 mit dem Festharz. Die Ergebnisse belegen weiterhin, daß man durch Variation der Flüssigharzkonzentration in der Zusammensetzung und auch über den Gehalt an Vinylgruppen im Harz die mechanischen Elastomereigenschaften steuern und beliebig einstellen kann. Die erfindungsgemäßen flüssigen Organopolysiloxan-Harze sind somit zur Verstärkung von vernetzbaren Polydiorganosiloxan-Zusammensetzungen sehr gut geeignet.

**Patentansprüche**

1.   Flüssige Organopolysiloxan-Harze der mittleren Zusammensetzung:

$$[R^1Si(CH_3)_2O_{1/2}]_a \, [(CH_3)_3SiO_{1/2}]_b \, [R^2O_{1/2}]_c \, [R^1Si(CH_3)O]_d \, [(CH_3)_2SiO]_e$$

$$[SiO_2],$$

wobei

$R^1$          einen $C_2$-$C_8$-Alkenylrest,

$R^2$          gegebenenfalls substituierte, lineare oder verzweigte $C_1$-$C_8$-Alkyl-Gruppen bzw. Mischungen daraus darstellt,

a+b+c+d+e    im Bereich von 1,0 bis 6,0 liegt,

d+e          Werte von 0 bis 3,0 einnehmen können,

und das Harz eine Viskosität von 0,1 bis 1000 Pas bei 25°C besitzt,
sowie der Alkenyl- bzw. Vinyl-Gehalt des Harzes in einem Bereich von 0,4 bis 4,0 mmol/g liegt.

2.   Verfahren zur Herstellung von flüssigen Organopolysiloxan-Harzen nach Anspruch 1, **dadurch gekennzeichnet, daß** mindestens ein Tetraalkoxysilan und/oder dessen Teilhydrolysate mit mindestens einem Organosiloxan und einer starken Säure als Katalysator in Gegenwart von Wasser und gegebenenfalls einem organischen Lösemittel bei Temperaturen > 40°C umgesetzt wird.

3.   Niedrigviskose Polydiorganosiloxan-Zusammensetzungen, enthaltend

a) mindestens ein flüssiges Organopolysiloxanharz der mittleren Zusammensetzung

$$[R^1Si(CH_3)_2O_{1/2}]_a \, [(CH_3)_3SiO_{1/2}]_b \, [R^2O_{1/2}]_c \, [R^1Si(CH_3)O]_d$$

$$[(CH_3)_2SiO]_e \, [SiO_2],$$

wobei

$R^1$          einen $C_2$-$C_8$-Alkenylrest, bevorzugt Vinyl-Rest,

$R^2$          gegebenenfalls substituierte, lineare oder verzweigte $C_1$-$C_8$-Alkyl-Gruppen bzw. Mischungen daraus darstellt,

a+b+c+d+e      im Bereich von 1,0 bis 4,0 liegt,

d+e               Werte von 0 bis 3,0 einnehmen können,

und das Harz eine Viskosität von 0,1 bis 1000 Pas bei 25°C besitzt,
sowie der Alkenyl- bzw. Vinyl-Gehalt des Harzes in einem Bereich von 0,4 bis 4,0 mmol/g liegt,

b) mindestens ein Alkenylgruppen-haltiges vernetzungsfähiges Polydiorganosiloxan der Formel

$$R^3\text{-Si}(R^4)_2O\text{-}[\text{-Si}(R^3)_2O]_x\text{-Si}(R^4)_2R^3,$$

wobei

$R^3$ und $R^4$      gegebenenfalls substituierte, lineare oder verzweigte $C_1$-C8-Alkylreste bedeuten und x in einem Bereich liegt, daß die Viskosität des Polymeren 0,1 bis 1000 Pas bei 25°C beträgt,

c) mindestens ein flüssiges Polyorganohydrogensiloxan der allgemeinen Formel

$$R^5\text{-Si}(R^6)_2O\text{-}[\text{-Si}(R^6)_2O]_n\text{-}[\text{-SiH}(R^6)O]_m\text{-Si}(R^6)_2R^5,$$

wobei

$R^6$      gegebenenfalls substituierte, lineare oder verzweigte $C_1$-$C_8$-Alkylreste bedeuten

$R^5$      die Bedeutung von $R^6$ oder Wasserstoff hat,

mit m > 2 für $R^6$ ungleich H und m=1 für $R^6$ = H,
n + m Werte einnehmen, daß die Viskosität des Polymers in einem Bereich von 5 bis 10000 mPas bei 25°C liegt, oder SiH-gruppenhaltige Polysiloxane, die als weitere Gruppen $(SiO_2)$- und $(R^6SiO_{3/2})$-Einheiten enthalten,

d) mindestens ein Hydrosilylierungskatalysator aus der Gruppe der Platinmetalle bzw. deren Verbindungen,

e) gegebenenfalls ein oder mehrere Füllstoffe und

f) gegebenenfalls weiterer Hilfstoffe.

4.  Niedrigviskose Polydiorganosiloxan-Zusammensetzungen nach Anspruch 3, **dadurch gekennzeichnet, daß** das molare Verhältnis der Hydrogen- zu Alkenyl-Gruppen zwischen 1:1 bis zu 3:1 beträgt.

5.  Niedrigviskose Polydiorganosiloxan-Zusammensetzungen nach einem der Ansprüche 3 oder 4, **dadurch gekennzeichnet, daß** der Hydrosilylierungskatalysator ein Platin(0)-Komplex mit Vinylsiloxanen als Liganden, Hexachloroplatin(IV)-säure und deren Komplexe mit ethylenischen ungesättigten Verbindungen ist.

6.  Niedrigviskose Polydiorganosiloxan-Zusammensetzungen nach einem der Ansprüche 3 bis 5, **dadurch gekennzeichnet, daß** die Platin-Konzentration des Hydrosilylierungskatalysators 0,1 bis 500 ppm Platin, bezogen auf die Gesamtmischung aus den Komponenten a) bis f), beträgt.

7.  Niedrigviskose Polydiorganosiloxan-Zusammensetzungen nach einem der Ansprüche 3 bis 6, **dadurch gekennzeichnet, daß** die Füllstoffe e) gegebenenfalls oberflächenmodifizierte pyrogene oder gefällte, feinteilige Kieselsäure mit einer BET-Oberfläche von 50 bis 500 $m^2$/g, Diatomeenerden, feinteilige Quarzmehle, amorphe Kieselsäuren, Calciumcarbonat, Metalloxide oder Ruße sind.

8.  Niedrigviskose Polydiorganosiloxan-Zusammensetzungen nach einem der Ansprüche 3 bis 7, **dadurch gekennzeichnet, daß** die Hilfsstoffe f) 2-Methyl-butin(3)-ol(2), Ethinylcyclohexanol, Tetramethylvinylcyclotetrasiloxan oder 1,3-Divinyl-1,1,3,3-tetramethyldivinyldisiloxan sind.

**9.** Niedrigviskose Polydiorganosiloxan-Zusammensetzungen nach einem der Ansprüche 3 bis 8, **dadurch gekennzeichnet, daß** diese

100 Gew.-Teile a)
20 bis 100 Gew.-Teile b)
1 bis 50 Gew.-Teile c)
1 bis 250 ppm d)
0 bis 200 Gew.-Teile e) enthalten.

**10.** Verwendung der niedrigviskosen Polydiorganosiloxan-Zusammensetzungen nach den Ansprüchen 3 bis 9 als Verguß- und Einbettungsmassen zur Abdichtung von elektronischen und elektrischen Bauteilen, zur Herstellung von Abform- und Abdruckmassen sowie als Beschichtungsmassen für Gewebe und andere verschiedene Materialien.

## Claims

**1.** Liquid organopolysiloxane resins of the average composition:

$$[R^1 Si (CH_3)_2 O_{1/2}]_a [(CH_3)_3 SiO_{1/2}]_b [R^2 O_{1/2}]_c$$

$$[R^1 Si(CH_3)O]_d [(CH_3)_2 SiO]_e [SiO_2],$$

where

R$^1$ is a $C_2$-$C_8$-alkenyl radical,
R$^2$ is unsubstituted or substituted, linear or branched $C_1$-$C_8$-alkyl groups or mixtures of these,
a + b + c + d + e is in the range from 1.0 to 6.0,
d + e can assume values from 0 to 3.0,

and the resin has a viscosity from 0.1 to 1 000 Pas at 25°C,
and the alkenyl or vinyl content of the resin is in the range from 0.4 to 4.0 mmol/g.

**2.** Process for preparing liquid organopolysiloxane resins according to Claim 1, **characterized in that** at least one tetraalkoxysilane, and/or its partial hydrolysates, is reacted with at least one organosiloxane and with a strong acid as catalyst, in the presence of water and, where appropriate, an organic solvent, at temperatures > 40°C.

**3.** Low-viscosity polydiorganosiloxane compositions, comprising

a) at least one liquid organopolysiloxane resin of the average composition

$$[R^1 Si (CH_3)_2 O_{1/2}]_a [(CH_3)_3 SiO_{1/2}]_b [R^2 O_{1/2}]_c$$

$$[R^1 Si(CH_3)O]_d [(CH_3)_2 SiO]_e [SiO_2],$$

where

R$^1$ is a $C_2$-$C_8$-alkenyl radical, preferably vinyl radical

R$^2$ is unsubstituted or substituted, linear or branched $C_1$-$C_8$-alkyl groups or mixtures of these,

a + b + c + d + e is in the range from 1.0 to 4.0,

d + e can assume values from 0 to 3.0,

and the resin has a viscosity from 0.1 to 1 000 Pas at 25°C,
and the alkenyl or vinyl content of the resin is in the range from 0.4 to 4.0 mmol/g,

b) at least one crosslinkable polydiorganosiloxane which contains alkenyl groups and has the formula

$$R^3\text{-Si}(R^4)_2O\text{-}[\text{-Si}(R^3)_2O]_x\text{-Si}(R^4)_2R^3,$$

where

$R^3$ and $R^4$     are unsubstituted or substituted, linear or branched $C_1$-$C_8$-alkyl radicals, and x lies within a range that [sic] the viscosity of the polymer is from 0.1 to 1 000 Pas at 25°C,

c) at least one liquid polyorganohydrosiloxane of the general formula

$$R^5\text{-Si}(R^6)_2O\text{-}[\text{-Si}(R^6)_2O]_n\text{-}[\text{SiH}(R^6)\,O]_m\text{-Si}(R^6)_2R^5,$$

where

$R^6$     are unsubstituted or substituted, linear or branched $C_1$-$C_8$-alkyl radicals,

$R^5$     is as defined for $R^6$ or is hydrogen,

where m > 2 for $R^6$ other than H, and m = 1 for $R^6$ = H,
n + m assume values that [sic] the viscosity of the polymer is in the range from 5 to 10 000 mPas at 25°C,
or polysiloxanes which contain SiH groups and contain other groups which are ($SiO_2$) units and ($R^6SiO_{3/2}$) units,

d) at least one hydrosilylation catalyst selected from the group consisting of the platinum metals and compounds of these,

e) where appropriate, one or more fillers, and

f) where appropriate, other auxiliaries.

4. Low-viscosity polydiorganosiloxane compositions according to Claim 3, **characterized in that** the molar ratio of the hydrogen groups to the alkenyl groups is from 1:1 to 3:1.

5. Low-viscosity polydiorganosiloxane compositions according to Claim 3 or 4, **characterized in that** the hydrosilylation catalyst is a platinum(0) complex with vinylsiloxanes as ligands, hexachloroplatinic (IV) acid, or complexes thereof with ethylenically unsaturated compounds.

6. Low-viscosity polydiorganosiloxane compositions according to any of Claims 3 to 5, **characterized in that** the platinum concentration in the hydrosilylation catalyst is from 0.1 to 500 ppm of platinum, based on the entire mixture made from components a) to f).

7. Low-viscosity polydiorganosiloxane compositions according to any of Claims 3 to 6, **characterized in that** the fillers e) are surface-modified or non-surface-modified fumed or precipitated, fine-particle silica with a BET surface area of from 50 to 500 m²/g, diatomaceous earths, fine-particle powdered quartz, amorphous silica, calcium carbonate, metal oxides, or carbon blacks.

8. Low-viscosity polydiorganosiloxane compositions according to any of Claims 3 to 7, **characterized in that** the auxiliaries f) are 2-methylbut-3-yn-2-ol, ethynylcyclohexanol, tetramethylvinylcyclotetrasiloxane or 1,3-divinyl-1,1,3,3-tetramethyldivinyldisiloxane.

9. Low-viscosity polydiorganosiloxane compositions according to any of Claims 3 to 8, **characterized in that** these comprise

100 parts by weight of a)
from 20 to 100 parts by weight of b)

from 1 to 50 parts by weight of c)
from 1 to 250 ppm of d)
from 0 to 200 parts by weight of e).

**10.** Use of low-viscosity polydiorganosiloxane compositions according to Claims 3 to 9 as potting and embedding compounds for sealing electronic and electrical components, for producing mould-making compounds and impression materials, or else as coating compositions for textiles or various other materials.

**Revendications**

**1.** Résines liquides d'organopolysiloxanes à la composition moyenne :

$$[R^1Si(CH_3)_2O_{1/2}]_a[(CH_3)_3SiO_{1/2}]_b[R^2O_{1/2}]_c[R^1Si(CH_3)O]_d[(CH_3)_2SiO]_e[SiO_2],$$

dans laquelle

| | |
|---|---|
| $R^1$ | représente un groupe alcényle en $C_2$-$C_8$, |
| $R^2$ | représente un groupe alkyle à chaîne droite ou ramifiée en $C_1$-$C_8$, éventuellement substitué, ou un mélange de tels groupes, |
| a+b+c+d+e | a une valeur de 1,0 à 6,0, |
| d+e | peut prendre des valeurs de 0 à 3,0, |

la résine a une viscosité de 0,1 à 1000 Pa.s à 25°C,
et la teneur en groupes alcényle ou vinyle de la résine se situe dans l'intervalle de 0,4 à 4,0 mmol/g.

**2.** Procédé de préparation des résines d'organopolysiloxanes liquides selon la revendication 1, **caractérisé en ce que** l'on fait réagir au moins un tétraalcoxysilane et/ou son hydrolysat partiel avec au moins un organosiloxane et un acide fort qui sert de catalyseur en présence d'eau et le cas échéant d'un solvant organique à des températures supérieures à 40°C.

**3.** Compositions de polydiorganosiloxanes à basse viscosité, contenant

a) au moins un résine d'organopolysiloxane liquide à la composition moyenne

$$[R^1Si(CH_3)_2O_{1/2}]_a[(CH_3)_3SiO_{1/2}]_b[R^2O_{1/2}]_c[R^1Si(CH_3)O]_d[(CH_3)_2SiO]_e[SiO_2],$$

dans laquelle

| | |
|---|---|
| $R^1$ | représente un groupe alcényle en $C_2$-$C_8$, de préférence un groupe vinyle, |
| $R^2$ | représente un groupe alkyle à chaîne droite ou ramifiée en $C_1$-$C_8$, éventuellement substitué, ou un mélange de tels groupes, |
| a+b+c+d+e | a une valeur de 1,0 à 4,0, |
| d+e | peut prendre des valeurs de 0 à 3,0, |

la résine a une viscosité de 0,1 à 1000 Pa.s à 25°C,
et la teneur en groupes alcényle ou vinyle de la résine se situe dans l'intervalle de 0,4 à 4,0 mmol/g,
b) au moins un polydiorganosiloxane réticulable, contenant des groupes alcényle, de formule

$$R^3-Si(R^4)_2O-[-Si(R^3)_2O]_x-Si(R^4)_2R^3,$$

dans laquelle

| | |
|---|---|
| $R^3$ et $R^4$ | représentent des groupes alkyle à chaîne droite ou ramifiée en $C_1$-$C_8$, éventuellement substitués, et x se situe dans un intervalle tel que la viscosité du polymère est de 0,1 à 1000 Pa.s à 25°C, |

c) au moins un polyorganohydrogénosiloxane liquide de formule générale

$$R^5\text{-Si}(R^6)_2\text{O-[-Si}(R^6)_2\text{O]}_n\text{-[-SiH}(R^6)\text{O]}_m\text{-Si}(R^6)_2R^5,$$

dans laquelle

$R^6$      représente un groupe alkyle à chaîne droite ou ramifiée en $C_1$-$C_8$, éventuellement substitué,

$R^5$      a les mêmes significations que $R^6$ ou représente l'hydrogène, sous réserve que m> 2 lorsque $R^6$ a une signification autre que H et m = 1 lorsque $R^6$ = H,

n + m peut prendre des valeurs telles que la viscosité du polymère se situe dans l'intervalle de 5 à 10000 mPa.s à 25°C,

ou des polysiloxanes à groupes SiH et contenant en outre des motifs $(SiO_2)$ et $(R^6SiO_{3/2})$,

d) au moins un catalyseur d'hydrosilylation pris dans le groupe des métaux de la série du platine et leurs dérivés,

e) le cas échéant une ou plusieurs matières de charge, et

f) le cas échéant d'autres produits auxiliaires.

4. Compositions de polydiorganosiloxanes à basse viscosité selon la revendication 3, **caractérisées en ce que** le rapport molaire entre l'hydrogène et les groupes alcényle va de 1:1 à 3:1.

5. Compositions de polydiorganosiloxanes à basse viscosité selon l'une des revendications 3 ou 4, **caractérisées en ce que** le catalyseur d'hydrosilylation est un complexe du platine (0) avec, en tant que ligands, des vinylsiloxanes, l'acide hexachloroplatinique-IV et ses complexes avec des composés à insaturation éthylénique.

6. Compositions de polydiorganosiloxanes à basse viscosité selon l'une des revendications 3 à 5, **caractérisées en ce que** la concentration en platine du catalyseur d'hydrosilylation est de 0,1 à 500 ppm de platine, par rapport au mélange total des composants a) à f).

7. Compositions de polydiorganosiloxanes à basse viscosité selon l'une des revendications 3 à 6, **caractérisées en ce que** les matières de charge e) consistent en silice pyrogène ou précipitée, en fines particules, éventuellement modifiée en surface, à une surface BET de 50 à 500 $m^2$/g, terre de diatomées, farine fine de quartz, silice amorphe, carbonate de calcium, oxydes métalliques ou noirs de carbone.

8. Compositions de polydiorganosiloxanes à basse viscosité selon l'une des revendications 3 à 7, **caractérisées en ce que** les produits auxiliaires f) consistent en le 2-méthyl-butyn(3)-ol(2), l'éthynylcyclohexanol, le tétraméthylvinyl-cyclotétrasiloxane ou le 1,3-divinyl-1,1,3,3-tétraméthyldivinyldisiloxane.

9. Compositions de polydiorganosiloxanes à basse viscosité selon l'une des revendications 3 à 8, **caractérisées en ce qu'**elles contiennent

100 parties en poids de a)

20 à 100 parties en poids de b)

1 à 50 parties en poids de c)

1 à 250 ppm de d)

0 à 200 parties en poids de e).

10. Utilisation des compositions de polydiorganosiloxanes à basse viscosité selon les revendications 3 à 9 en tant que masses de jointoyage et d'enrobage assurant l'étanchéité de pièces électroniques et électriques, pour la préparation de masses à reproduire par moulage ou impression ou en tant que masses de revêtement pour des tissus et d'autres matières variées.